Europäisches Patentamt

European Patent Office

Office européen des brevets

(11) Veröffentlichungsnummer: **0 275 433 B1**

(12) **EUROPÄISCHE PATENTSCHRIFT**

(45) Veröffentlichungstag der Patentschrift: **01.04.92**

(21) Anmeldenummer: **87117832.3**

(22) Anmeldetag: **02.12.87**

(51) Int. Cl.⁵: **H01L 21/60**

(54) **Verfahren zur Befestigung von elektronischen Bauelementen auf einem Substrat, Folie zur Durchführung des Verfahrens und Verfahren zur Herstellung der Folie.**

(30) Priorität: **22.12.86 DE 3644044**

(43) Veröffentlichungstag der Anmeldung:
**27.07.88 Patentblatt 88/30**

(45) Bekanntmachung des Hinweises auf die Patenterteilung:
**01.04.92 Patentblatt 92/14**

(84) Benannte Vertragsstaaten:
**DE FR GB IT SE**

(56) Entgegenhaltungen:
**EP-A- 0 134 623**
**DE-A- 3 414 065**

(73) Patentinhaber: **SIEMENS AKTIENGESELL-SCHAFT**
**Wittelsbacherplatz 2**
**W-8000 München 2(DE)**

(72) Erfinder: **Baumgartner, Werner**
**Hugo-Tröndle-Strasse 23**
**W-8000 München 50(DE)**
Erfinder: **Fellinger, Johannes**
**von Stauffenberg-Strasse 3**
**W-8025 Unterhaching(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Verfahren zur Befestigung von elektronischen Bauelementen auf einem Substrat, Folie zur Durchführung des Verfahrens und Verfahren zur Herstellung der Folie
Die Erfindung betrifft ein Verfahren zur Befestigung von elektronischen Bauelementen auf einem Substrat mittels einer aus Metallpulver gesinterten Verbindungsschicht, eine Folie zur Durchführung des Verfahrens, sowie ein Verfahren zur Herstellung einer derartigen Folie.

Anordnungen, bei denen Bauteile auf Substraten befestigt sind und Verfahren zur deren Herstellung sind aus verschiedenen Druckschriften bekannt. Die zur Befestigung nötige Verbindungsschicht zwischen Bauteil und Substrat kann verschiedenartig hergestellt werden, soll jedoch immer den gleichen Anforderungen bezüglich niedrigem elektrischen Widerstand, hoher Wärmeleitfähigkeit und hoher Haftfestigkeit genügen.

Aus DE-OS 34 14 065 ist bekannt, die Verbindungsschicht ausschließlich aus durch Trockensintern verfestigtem Metallpulver herzustellen, wobei einerseits die Kontaktierungsschicht des Bauelementes und andererseits die Kontaktoberfläche des Substrates mit angesintert werden. Auf Bindemittel wie Glas oder Klebstoff wird verzichtet. Das Herstellungsverfahren dieser Anordnung sieht vor, daß eine aus Metallpulver und einem Lösungsmittel bestehende Paste schichtförmig auf die Kontaktierungsschicht des Bauelementes und/oder die Kontaktoberfläche des Subtrats aufgetragen wird, das Bauelement auf das Substrat bzw. die Paste aufgesetzt wird, das Lösungsmittel vollständig ausgetrieben wird und die gesamte Anordnung zur Bildung der Verbindungsschicht auf Sintertemperatur erwärmt wird. Hierbei ist es grundsätzlich möglich, die Paste vor dem Aufsetzen des Bauteiles im Vakuum zu entgasen, anschließend vorzutrocknen und nach dem Aufsetzen des Bauteiles das Lösungsmittel vollständig auszutreiben, sowie den Sintervorgang anschließend durchzuführen. Die Sintertemperaturen liegen hier zwischen 380 und 420° C, der mechanische Druck wird auf einen Wert zwischen 80 und 90 N/cm$^2$ eingestellt.

Aus der älteren Patentanmeldung mit dem amtlichen Aktenzeichen P 36 13 572.0 ist bekannt, daß die vor dem Aufsetzen des Bauelementes auf das Substrat und/oder auf das Bauelement aufgetragene Paste vollständig getrocknet werden muß. Diese Verfahrensweise ist besonders bei großflächigen Bauelementen wichtig, da ein Trocknen der Paste nachdem das Bauelement bereits aufgesetzt wurde zu Fehlern in der Verbindungsschicht führt. Nachteile dieser Verfahrensweise werden durch einen sehr hohen mechanischen Druck während des Sinterprozesses von mindestens 900 N/cm$^2$ kompensiert.

Aus der europäischen Patentanmeldung EP-A3-0 134 623 ist ein als Klebeschicht ausgebildetes Transferband bekannt, welches in einer Matrix von einem organischen Material elektrisch und thermisch leitende Teilchen (18) enthält. Diese Teilchen sind beispielsweise aus Silber, vorzugsweise kugelförmig und größer, als die Stärke der eigentlichen Klebeschicht. Während des Verbindungsvorganges werden durch Auswirkung äußeren Druckes die Teilchen verformt und bilden somit kleine, flächige, leitfähige Zonen.

Der Erfindung liegt die Aufgabe zugrunde, ein Verfahren zur Befestigung von elektronischen Bauelementen auf einem Substrat mittels einer aus Metallpulver gesinterten Verbindungsschicht zu schaffen, wobei die Stärke dieser Verbindungsschicht in weiten Grenzen variiert werden kann. Außerdem soll die Handhabung während des Verfahrens dahingehend vereinfacht werden, daß die Zeit zum Trocknen der Paste entfällt.

Diese Aufgabe wird durch ein Verfahren zur Befestigung von elektronischen Bauelementen auf einem Substrat mittels einer aus Metallpulver gesinterten Verbindungsschicht gelöst, bei welchem das Metallpulver vor dem Sintervorgang in Form einer vorgesinterten Folie zwischen Bauelement und Substrat eingebracht wird. Die Folie besteht aus flächig ausgebreiteten durch Vorsinterung zusammenhängendem Metallpulver. Sie wird in einem eigenen Verfahren hergestellt, wobei

a) Metallpulver mit einem Lösungsmittel zu einer Paste vermischt wird,
b) die Paste mittels einer Rakelvorrichtung auf eine Unterlage aufgebracht wird,
c) durch Wärmezufuhr das Lösungsmittel aus der Paste ausgetrieben wird,
d) die Metallpulverteilchen durch Vorsinterung zumindest teilweise miteinander versintert werden,
e) die so entstandene Folie von der Unterlage abgehoben wird.

Der Erfindung liegt die Erkenntnis zugrunde, daß der Ver-Verfahrensschritt bei dem das Lösunsmittel aus der Paste ausgetrieben wird, zweckmäßigerweise nicht während der eigentlichen Befestigung des elektronischen Bauelementes auf dem Substrat durchgeführt wird.

Durch die Herstellung einer Folie in einem externen Verfahren liegt das Ausgangsmaterial für die spätere Verbindungsschicht in Form einer lösungsmittelfreien Schicht aus Metallpulverteilchen, der Folie, vor, die ihre mechanische Festigkeit durch Vorsinterung erhalten hat. Die so entstandene Folie wird entsprechend der Querschnittfläche des elektronischen Bauelementes ausgestanzt und dem Verfahren zur Befestigung des elektronischen Bauelementes auf einem Substrat zugeführt.

Gemäß einer bevorzugten Ausgestaltung der Erfindung wird auf Bauelement, Folie und Substrat während des Sintervorganges ein mechanischer Druck von mindestens 30 N/cm$^2$ ausgeübt. Durch den Einsatz einer Folie reicht dieser relativ niedrige Druck aus um eine gute Haftfestigkeit zu erreichen und schont zugleich das Bauelement vor zu großer mechanischer Belastung.

Weiterhin führt der Einsatz einer Folie beim beschriebenen Drucksinterverfahren dazu, daß der Sintervorgang bei der für diesen Prozeß mindestens einzustellenden Temperatur von 150° C durchgeführt werden kann.

Die für die Folie charakteristischen mechanischen Eigenschaften resultieren aus der Vorsinterung des flächig ausgebreiteten Metallpulvers, wodurch die einzelnen Metallpulverteilchen durch Verringerung des Porenvolumens und durch Hals-bildung zusammenhängen. Entsprechend dem Grad der Vorsinterung oder der Energie die während der Vorsinterung eingebracht wird, bezogen auf die Energie die dem gesamten Sinterprozeß zugeführt werden muß, ist die Feinstruktur der Folie vorgegeben und beeinflußt direkt das Verfahren zur Befestigung von elektronischen Bauelementen auf einem Substrat.

Entsprechend einer weiteren bevorzugten Ausgestaltung der Erfindung besteht die Folie aus Edelmetall oder einer Edelmetallegierung. Besonders günstig erwies sich dabei die Verwendung von Silber.

Um die Folie bezüglich des Verhaltens beim Sintern zu optimieren wird bevorzugt ein Metallpulver bestehend aus plättchenförmigen Metallpulverteilchen verwendet, wobei die Korngröße bei maximal 15 μm liegt. Durch diese und insbesondere auch durch die vorgenannte Ausgestaltung der Erfindung wird für besonders gute elektrische und thermische Leitfähigkeit der Verbindungsschicht gesorgt.

Das Herstellungsverfahren der Folie, welches von dem eigentlichen Verfahren zur Befestigung von elektronischen Bauelementen auf einem Substrat separiert ist, bietet die Möglichkeit die Eigenschaften der Folie, die Ausgangsmaterial für die spätere Verbindungsschicht ist, in weiten Grenzen vorzubestimmen. Dieses externe Verfahren entlastet die elektronischen Bauteile und das Substrat bezüglich der Wärmebelastung, da ein Teil der zur Herstellung der Verbindungsschicht nötigen Wärmemenge schon während der Vorsinterung eingebracht wird und nimmt den zeitaufwendigen Schritt für die Trocknung der Paste aus dem eigentlichen Verfahren zur Herstellung der Verbindungsschicht heraus.

Bei einer bevorzugten Ausgestaltung des Verfahrens zur Herstellung der Folie wird als Lösungsmittel ein Gemisch aus Cyclohexanol und Menthol eingesetzt, wobei sich herausstellte, daß die besten Eigenschaften bei einer Mischung im Gewichtsverhältnis von 1 : 1 erhalten werden. Ein so erhaltenes Lösungsmittel hat den besonderen Vorteil, daß es sich nicht zu schnell verflüchtigt, d. h. daß die Paste länger gelagert werden kann.

Ein optimales Verhältnis zwischen Lösungsmittel und Metallpulver bei der Herstellung der Paste ist bei 1 : 4,8 gegeben. Mit diesem Wert werden sehr gute Stoffeigenschaften der Paste bezüglich der Verarbeitbarkeit erreicht.

Bei einer bevorzugten Ausgestaltung der Erfindung wird die fertige Folie nach dem Ablösen von der Unterlage in einem Kolander bearbeitet. Hierdurch kann, falls nötig, die Schichtdicke der Folie vergleichsmäßigt werden. Es sind grundsätzlich Schichtdicken von mindestens 5 μm erreichbar.

Sind beim Einsatz von Siebdruckverfahren Schichtdicken der Paste zwischen 10 und 100 μm herzustellen, so lassen sich mit der hier eingesetzen Rakelmethode Schichtstärken zwischen 10 und 500 μm erhalten.

Eine weitere bevorzugte Ausgestaltung der Erfindung beinhaltet, daß die Aufheizgeschwindigkeit beim Austreiben des Lösungsmittels aus der Paste zwischen 5 und 30° C/Min beträgt. Die optimalsten Eigenschaften der Folie wurden durch eine Vorsinterung bei einer Temperatur von 220° C erreicht. Die maximale Temperatur sollte 300° C nicht übersteigen. Dabei hat sich herausgestellt, daß diese Temperatur als Temperaturmaximum über eine Haltezeit von 0,5 bis zu 5 Minuten gehalten werden muß.

Ausführungsbeispiele der Erfindung sind in der Zeichnung dargestellt und werden im folgenden näher beschrieben.

Die Figuren zeigen im einzelnen:

FIG 1 zeigt die Lage und Anordnung der Einzelteile vor der Befestigung des elektronischen Bauelementes B auf dem Substrat S und die Folie F,

FIG 2 zeigt die gleiche Anordnung nach der Fertigsinterung, wobei die Verbindungsschicht VS bereits gebildet ist.

In FIG 1 wird ersichtlich, daß das Substrat S mit der Kontaktoberfläche KO versehen ist und das elektronische Bauteil B mit der Kontaktschicht KS. KO und KS, aus ähnlichem Material wie die Folie F hergestellt, sind im Verhältnis zur Folie F übertrieben groß gezeichnet. KS und KO liegen in der Regel im Bereich unter 15 μm, die Stärke der Folie F kann je nach Bedarfsfall variieren und bis zu 250 μm oder mehr betragen. Die Folie F ist in einem eigenen Verfahren aus einer Metall-Lösungsmittel-Paste hergestellt worden, ist bereits lösungsmittelfrei vorgesintert und entsprechend der Querschnittsfläche des Bauelements B ausgestanzt worden. Es wird insbesondere eine Silberfolie aus einer Silberpaste hergestellt, die mittels einer Rakelvorrichtung in Schichtstärken zwischen 10 und 500 $\mu$m auf eine geeignete Unterlage aufgebracht wurde. Als geeignete Unterlagen können verwendet werden - poliertes Silizium, Glas, Quarz. Zum Austreiben des Lösungsmittels wurden eine Aufheizrate von ca. 20° C/Min und eine maximale Temperatur von 220° C eingestellt. Diese maximale Temperatur wurde ca. 2 Minuten lang gehalten. Das Lösungsmittel war in diesem Fall eine Mischung aus Cyclohexanol und Methanol im Gewichtsverhältnis von 1 : 1. Das Verhältnis Lösungsmittel zu Silberpulver betrug 1 : 4,8.

FIG 2 zeigt eine entsprechende Anordnung wie FIG 1, wobei die Bauteile durch den mechanischen Druck P zusammengedrückt werden, die Folie bereits zur Verbindungsschicht VS umgewandelt wurde und somit eine Befestigung des elektronischen Bauteiles auf dem Substrat S erreicht ist.

**Patentansprüche**

1. Verfahren zur Befestigung von elektronischen Bauelementen (B) auf einem Substrat (S) mittels einer aus Metallpulver gesinterten Verbindungsschicht (VS), dadurch **gekennzeichnet**, daß das Metallpulver vor dem Sintervorgang in Form einer vorgesinterten Folie (F) zwischen Bauelement (B) und Substrat (S) eingebracht wird.

2. Verfahren nach Anspruch 1, dadurch **gekennzeichnet**, daß Bauelement (B), Folie (F) und Substrat (S) während des Sintervorganges mit einem Druck von mindestens 30 N/cm$^2$ zusammengedrückt werden.

3. Verfahren nach Anspruch 1 oder 2, dadurch **gekennzeichnet**, daß der Sintervorgang bei Temperaturen von mindestens 150° C durchgeführt wird.

4. Folie zur Durchführung des Verfahrens nach einem der Ansprüche 1 bis 3, dadurch **gekennzeichnet**, daß die Folie aus flächig ausgebreitetem durch Vorsinterung zusammenhängendem Metallpulver besteht.

5. Folie nach Anspruch 4, dadurch **gekennzeichnet**, daß die Folie aus Edelmetall oder einer Edelmetalllegierung besteht.

6. Folie nach Anspruch 5, dadurch **gekennzeichnet**, daß die Folie aus Silber besteht.

7. Folie nach einem der Ansprüche 4 bis 6, dadurch **gekennzeichnet**, daß die Folie aus plättchenförmigen Metallpulverteilchen besteht, deren Korngröße maximal 15 $\mu$m beträgt.

8. Verfahren zur Herstellung einer Folie nach einem der Ansprüche 4 bis 7, dadurch **gekennzeichnet**, daß
   a. Metallpulver mit einem Lösungsmittel zu einer Paste vermischt wird,
   b. die Paste mittels einer Rakelvorrichtung auf eine Unterlage aufgebracht wird,
   c. durch Wärmezufuhr das Lösungsmittel aus der Paste ausgetrieben wird,
   d. die Metallpulverteilchen durch Vorsinterung zumindest teilweise miteinander versintert werden,
   e. die so entstandene Folie von der Unterlage abgehoben wird.

9. Verfahren nach Anspruch 8, dadurch **gekennzeichnet**, daß als Lösungsmittel ein Gemisch aus Cyclohexanol und Menthol im Gewichtsverhältnis in den Grenzen von 1 : 1 bis 1 : 10 verwendet wird.

10. Verfahren nach Anspruch 9, dadurch **gekennzeichnet**, daß Cyclohexanol und Menthol im Gewichtsverhältnis 1 : 1 gemischt werden.

11. Verfahren nach einem der Ansprüche 8 bis 10, dadurch **gekennzeichnet**, daß die Paste aus einem Gemisch von Lösungsmittel und Metallpulver im Gewichtsverhältnis in den Grenzen von 1 : 4 bis 1 : 6 besteht.

12. Verfahren nach Anspruch 11, dadurch **gekennzeichnet**, daß das Gewichtsverhältnis zwischen Lösungsmittel und Metallpulver 1 : 4,8 beträgt.

13. Verfahren nach einem der Ansprüche 8 bis 12, **dadurch gekennzeichnet**, daß die Folie mit einem Kolander nachgearbeitet wird.

14. Verfahren nach Anspruch 13, dadurch **gekennzeichnet**, daß die Folie eine homogene Schichtdicke erhält, die mindestens 5 $\mu$m beträgt.

15. Verfahren nach einem der Ansprüche 8 bis 14, **dadurch gekennzeichnet**, daß die Paste mit einer Schichtstärke zwischen 10 und 500 $\mu$m aufgerakelt wird.

16. Verfahren nach einem der Ansprüche 8 bis 15, **dadurch gekennzeichnet**, daß zum Austreiben des Lösungsmittels und zum Vorsintern des Metallpulvers Aufheizgeschwindigkeiten von 5 bis 30° C/Min eingestellt werden.

**17.** Verfahren nach einem der Ansprüche 8 bis 16, dadurch **gekennzeichnet**, daß das Temperaturmaximum bei ca. 300° C liegt.

**18.** Verfahren nach einem der Ansprüche 8 bis 17, **dadurch gekennzeichnet**, daß die Haltezeit, während der die maximal eingestellte Temperatur gehalten wird, zwischen 0,5 und 5 Minuten beträgt.

**Claims**

**1.** Method of fastening electronic components (B) on a substrate (S) by means of a bonding layer (VS) sintered from metal powder, characterised in that, before the sintering operation, the metal powder is introduced in the form of a presintered film (F) between component (B) and substrate (S).

**2.** Method according to Claim 1, characterised in that component (B), film (F) and substrate (S) are pressed together during the sintering operation under a pressure of at least 30 N/cm$^2$.

**3.** Method according to Claim 1 or 2, characterised in that the sintering operation is carried out at temperatures of at least 150° C.

**4.** Film for carrying out the method according to one of Claims 1 to 3, characterised in that the film consists of metal powder spread out over a surface area and cohering due to presintering.

**5.** Film according to Claim 4, characterised in that the film consists of precious metal or a precious metal alloy.

**6.** Film according to Claim 5, characterised in that the film consists of silver.

**7.** Film according to one of Claims 4 to 6, characterised in that the film consists of metal powder particles in lamina form, the grain size of which is a maximum of 15 $\mu$m.

**8.** Process for producing a film according to one of Claims 4 to 7, characterised in that,
a. metal powder is mixed with a solvent to form a paste,
b. the paste is applied to a base by means of a doctor blade device,
c. the solvent is driven out from the paste by supplying heat,
d. the metal powder particles are sintered at least partially with one another by presintering,

e. the film thus produced is lifted off the base.

**9.** Process according to Claim 8, characterised in that a mixture of cyclohexanol and menthol in a weight ratio within the limits of 1 : 1 to 1 : 10 is used as solvent.

**10.** Process according to Claim 9, characterised in that cyclohexanol and menthol are mixed in a weight ratio of 1 : 1.

**11.** Process according to one of Claims 8 to 10, characterised in that the paste consists of a mixture of solvent and metal powder in a weight ratio within the limits of 1 : 4 to 1 : 6.

**12.** Process according to Claim 11, characterised in that the weight ratio between solvent and metal powder is 1 : 4.8.

**13.** Process according to one of Claims 8 to 12, characterised in that the film is subsequently treated with a calender.

**14.** Process according to Claim 13, characterised in that the film is given a homogenous layer thickness which is at least 5 $\mu$m.

**15.** Process according to one of Claims 8 to 14, characterised in that the paste is applied with the doctor blade in a layer thickness of between 10 and 500 $\mu$m.

**16.** Process according to one of Claims 8 to 15, characterised in that, for driving out the solvent and for presintering the metal powder, heating-up rates of from 5 to 30° C/min are set.

**17.** Process according to one of Claims 8 to 16, characterised in that the temperature maximum is about 300° C.

**18.** Process according to one of Claims 8 to 17, characterised in that the holding time during which the temperature set as a maximum is held is between 0.5 and 5 minutes.

**Revendications**

**1.** Procédé pour fixer des composants électroniques (B) sur un substrat (S) à l'aide d'une couche de liaison (VS) formée par frittage d'une poudre métallique, caractérisé par le fait qu'on introduit la poudre métallique avant l'opération de frittage sous la forme d'une feuille préalablement frittée (F), entre un composant (B) et le substrat (S).

**2.** Procédé suivant la revendication 1, caractérisé par le fait que l'on comprime le composant (B), la feuille (F) et le substrat (S) pendant l'opération de frittage avec une pression égale à au moins 30 N/cm$^2$.

**3.** Procédé suivant la revendication 1 ou 2, caractérisé par le fait qu'on exécute l'opération de frittage à une température d'au moins 150°C.

**4.** Feuille pour la mise en oeuvre du procédé suivant l'une des revendications 1 à 3, caractérisée par le fait que la feuille est constituée par une poudre métallique étalée à plat et liée au moyen d'un frittage préalable.

**5.** Feuille suivant la revendication 4, caractérisée par le fait que la feuille est constituée par un métal précieux ou un alliage de métal précieux.

**6.** Feuille suivant la revendication 5, caractérisée par le fait que la feuille est formée d'argent.

**7.** Feuille suivant l'une des revendications 4 à 6, caractérisée par le fait que la feuille est constituée par des particules en forme de plaquettes de poudre métallique, dont la taille des grains est égale au maximum à 15 $\mu$m.

**8.** Procédé pour fabriquer une feuille suivant l'une des revendications 4 à 7, caractérisé par le fait que

a. on mélange une poudre métallique à un solvant pour former une pâte,

b. on dépose la pâte sur un support à l'aide d'un dispositif à racle,

c. on évacue le solvant de la pâte au moyen d'un apport de chaleur,

d. on réunit au moins partiellement au moyen d'un frittage préalable les particules de la poudre métallique,

e. on retire du support la feuille ainsi obtenue.

**9.** Procédé suivant la revendication 8, caractérisé par le fait qu'on utilise comme solvant un mélange de cyclohexanol et de menthol dans un rapport pondéral compris dans les limites allant de 1:1 à 1:10.

**10.** Procédé suivant la revendication 9, caractérisé par le fait qu'on mélange du cyclohexanol et du menthol dans le rapport pondéral 1:1.

**11.** Procédé suivant l'une des revendications 8 à 10, caractérisé par le fait que la pâte est formée par un mélange d'un solvant et d'une poudre métallique dans le rapport pondéral situé dans les limites allant de 1:4 à 1:6.

**12.** Procédé suivant la revendication 11, caractérisé par le fait que le rapport pondéral entre le solvant et la poudre métallique est égal à 1:4,8.

**13.** Procédé suivant l'une des revendications 8 à 12, caractérisé par le fait qu'on applique un traitement ultérieur à la feuille à l'aide d'une calandre.

**14.** Procédé suivant la revendication 13, caractérisé par le fait qu'on donne à la feuille une épaisseur de couche homogène égale au moins à 5 $\mu$m.

**15.** Procédé suivant l'une des revendications 8 à 14, caractérisé par le fait qu'on dépose à la racle la pâte avec une épaisseur de couche comprise entre 10 et 500 $\mu$m.

**16.** Procédé suivant l'une des revendications 8 à 15, caractérisé par le fait que pour évacuer le solvant et réaliser le frittage préalable de la poudre métallique, on règle des vitesses de chauffage de 5 à 30°C/mn.

**17.** Procédé suivant l'une des revendications 8 à 7, caractérisé par le fait que la température maximale est égale à environ 300°C.

**18.** Procédé suivant l'une des revendications 8 à 17, caractérisé par le fait que le temps de maintien, pendant lequel la température maximale réglée est maintenue, est comprise entre 0,5 et 5 minutes.